# EUROPEAN PATENT SPECIFICATION

(11) **EP 3 478 047 B1**
(45) Date of publication and mention of the grant of the patent: **24.02.2021**
(21) Application number: 18201945.5
(22) Date of filing: 23.10.2018
(51) Int. Cl.: H05K 13/08, H05K 13/00, H05K 13/04

(54) **ASSEMBLY SYSTEM AND ASSEMBLING METHOD**
MONTAGESYSTEM UND MONTAGEVERFAHREN
SYSTÈME D'ASSEMBLAGE ET PROCÉDÉ D'ASSEMBLAGE

(30) Priority: 25.10.2017 CN 201711008175
(43) Date of publication of application: 01.05.2019
(73) Proprietor: Tyco Electronics (Shanghai) Co., Ltd., China (Shanghai) Pilot Free Trade Zone Shanghai (CN); Tyco Electronics Polska Sp. z.o.o., 02-677 Warsaw (PL); TE Connectivity Corporation, Berwyn, PA 19312 (US); Kunshan League Automechanism Co., Ltd., Kunshan City Jiangsu (CN)
(72) Inventor: DENG, Yingcong, Shanghai, Shanghai 200233 (CN); KOWALSKI, Jaroslaw, 85-059 Bydgoszcz (PL); PRZYBYLSKI, Andrzej, 85-059 Bydgoszcz (PL); GRZEBSKI, Jaroslaw, 85-059 Bydgoszcz (PL); ZHANG, Dandan, Shanghai, Shanghai 200233 (CN); HU, Lvhai, Shanghai, Shanghai 200233 (CN); XIE, Fengchun, Shanghai, Shanghai 200233 (CN); LIU, Yun, Shanghai, Shanghai 200233 (CN); LU, Roberto Francisco-Yi, Bellvue, WA Washington 98006 (US); WU, Haidong, Kunshan City, Jiangsu (CN); XIAO, Hui, Kunshan City, Jiangsu (CN)
(74) Representative: Grünecker Patent- und Rechtsanwälte PartG mbB

(56) References cited:
- EP-A1- 1 542 523
- EP-A1- 3 007 538
- FR-A1- 2 691 603
- US-A1- 2003 029 033

## Description

### BACKGROUND OF THE INVENTION

### Field of the Invention

The present disclosure relates to an assembly system and an assembling method, more particularly, relates to an assembly system and an assembling method adapted to mounting electronic devices on a circuit board.

### Description of the Related Art

In the field of electronic manufacturing, it often needs to mount various electronic devices, such as electronic components, electronic chips or semi-finished electronic products on a circuit board. In the related art, in order to improve the assembly efficiency, a vision-guided robot is usually used to complete the assembly work of the circuit board. Therefore, it needs to provide a visual system to identify a position and a posture of the circuit board. However, because a view field of a visual system, for example, a camera, is limited, it often cannot completely cover all surface areas of a plurality of circuit boards at the assembly station. In this way, in the prior art, only one circuit board can be assembled at an assembly station at a time, which reduces the assembly efficiency of the circuit board.

Further approaches for apparatuses and methods for mounting electronic parts are, for instance, shown in US 2003/029033 A1 or EP 1 542 523 A1. In documents FR 2 691 603 A1 and EP 3 007 538 A1 electronic apparatus assembly machines and corresponding methods are also shown.

### SUMMARY OF THE INVENTION

The present disclosure has been made to overcome or alleviate at least one aspect of the above mentioned disadvantages.

According to an aspect of the present disclosure, there is provided an assembly system, comprising: a robot adapted to grip an electronic device to be mounted on a circuit board; a first vision system configured to identify a position and a posture of the electronic device gripped by the robot; a fixing device adapted to fix a plurality of circuit boards thereon; and a second vision system configured to identify a position and a posture of the circuit board fixed on the fixing device, the robot is adapted to mount the gripped electronic device on the circuit board under the visual guidance of the first vision system and the second vision system, a view field of the second vision system is not capable of completely covering a surface region of all circuit boards fixed on the fixing device; the assembly system further comprises a moving mechanism adapted to move the second vision system in a first horizontal direction and a second horizontal direction perpendicular to the first horizontal direction, so that the second vision system completes identification of all circuit boards on the fixing device step by step, wherein the assembly system further comprises a rotatable table on which a plurality of fixing devices are mounted, the plurality of fixing devices are arranged around the periphery of rotatable table and separated from each other, the rotatable table is adapted to rotate the plurality of fixing devices in turn to an assembling station where the robot performs an assembly work of mounting electronic devices on the circuit boards fixed on one fixing device.

According to another exemplary embodiment, after the assembly work of all circuit boards on one fixing device is completed, the rotatable table is rotated forward by one step to move the assembled circuit boards to an unloading station and move the unassembled circuit boards fixed on another fixing device to the assembling station.

The plurality of circuit boards fixed on each fixing devices may be arranged in an array.

According to another exemplary embodiment, the moving mechanism comprising: a first horizontal moving mechanism adapted to move the second vision system in the first horizontal direction; and a second horizontal moving mechanism adapted to move the second vision system in the second horizontal direction, the second horizontal moving mechanism is mounted on the first horizontal moving mechanism, and the second vision system is mounted on the second horizontal moving mechanism.

The electronic device may comprise an electronic component, an electronic product or an electronic subassembly.

According to another exemplary embodiment of the present disclosure, the first vision system is adapted to detect whether a size and an appearance of the electronic device gripped by the robot meets a predetermined requirement.

According to another exemplary embodiment of the present disclosure, the second vision system is adapted to detect whether a size and an appearance of the circuit board fixed on the fixing device meets a predetermined requirement.

According to another aspect of the present disclosure, there is provided a method of assembling a circuit board, comprising steps of:
S100: providing the above assembly system;
S200: moving the unassembled circuit boards fixed on one fixing device to the assemble station by rotating the rotatable table forward by one step;
S300: synchronously performing following steps S310 and S320:
   S310: gripping the electronic device by the robot, and identifying the position and the posture of the electronic device by the first vision system;
   S320: moving the second vision system by the moving mechanism, and identifying the position and the posture of the unassembled circuit boards fixed on the one fixing device step by step by the second vision system;
S400: mounting the gripped electronic device on the circuit board by the robot under the visual guidance of the first vision system and the second vision system.

According to an exemplary embodiment of the present disclosure, the method further comprises a step of:
S500: rotating the rotatable table forward by one step, so as to move the assembled circuit boards fixed on the one fixing device to the assembling station and move the unassembled circuit boards fixed on another fixing device to the unloading station.

According to another exemplary embodiment of the present disclosure, the step S310 further comprises a step of detecting whether the electronic device gripped by the robot is qualified by the first vision system; the step S320 further comprises a step of detecting whether the unassembled circuit boards fixed on the one fixing device is qualified by the second vision system.

In the above various exemplary embodiments of the present disclosure, the moving mechanism is adapted to move the second vision system in a first horizontal direction and a second horizontal direction perpendicular to the first horizontal direction. In this way, all circuit boards on the fixing device may be identified by the second vision system. Thereby, the robot may complete the assembly work of all circuit boards at an assembly station at a time, improving the assembly efficiency of the circuit boards.

### BRIEF DESCRIPTION OF THE DRAWINGS

The above and other features of the present disclosure will become more apparent by describing in detail exemplary embodiments thereof with reference to the accompanying drawings, in which:

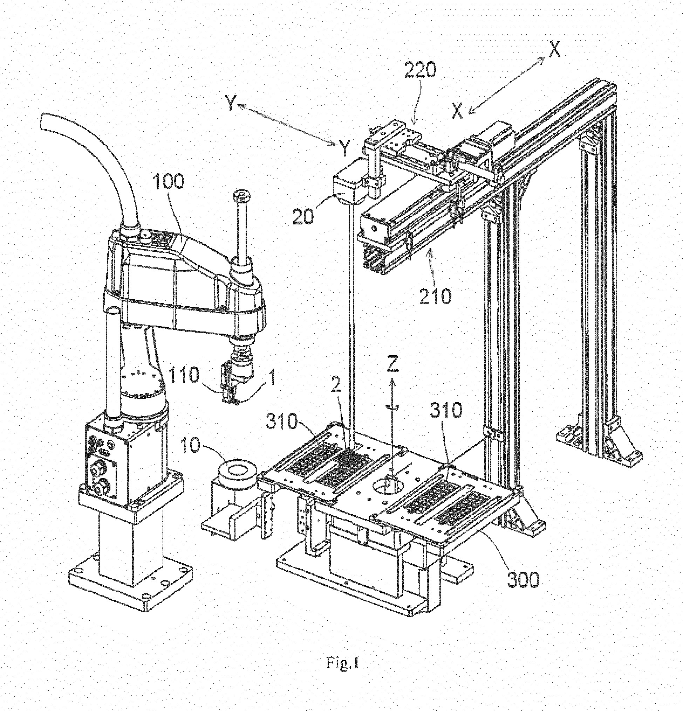

Fig.1 is an illustrated perspective view of an assembly system according to an embodiment of the present disclosure.

### DETAILED DESCRIPTION OF PREFERRED EMBODIMENTS OF THE INVENTION

Exemplary embodiments of the present disclosure will be described hereinafter in detail with reference to the attached drawings, wherein the like reference numerals refer to the like elements. The present invention should not be construed as being limited to the embodiment set forth herein, but is limited by the appended claims.

In the following detailed description, for purposes of explanation, numerous specific details are set forth in order to provide a thorough understanding of the disclosed embodiments. In other instances, well-known structures and devices are schematically shown in order to simplify the drawing.

Fig.1 is an illustrated perspective view of an assembly system according to an exemplary embodiment of the present disclosure.

As shown in Fig.1, the assembly system mainly comprises a robot 100, a first vision system 10, a fixing device 310, and a second vision system 20. The robot 100 is adapted to grip an electronic device 1 to be mounted on a circuit board 2 by a manipulator 110 which is mounted on an actuator of the robot 100. The first vision system 10 is configured to identify a position and a posture of the electronic device 1 gripped by the robot 100. The fixing device 310 is adapted to fix a plurality of circuit boards 2 thereon. The second vision system 20 is configured to identify a position and a posture of the circuit board 2 fixed on the fixing device 310. The robot 100 is adapted to mount the gripped electronic device 1 on the circuit board 2 under the visual guidance of the first vision system 10 and the second vision system 20.

As shown in Fig.1, a view field of the second vision system 20 is not capable of completely covering a surface region of all circuit boards 2 fixed on the fixing device 310. In order to identify all circuit boards 2 fixed on the fixing device 310, as shown in Fig.1, the assembly system further comprises a moving mechanism 210, 220 adapted to move the second vision system 20 in a first horizontal direction X and a second horizontal direction Y perpendicular to the first horizontal direction X. In this way, the second vision system 20 is capable of completing the identification of all circuit boards 2 on the fixing device 310 step by step.

As shown in Fig.1, the assembly system further comprises a rotatable table 300. The rotatable table 300 may be rotated about a vertical axis Z perpendicular to the first horizontal direction X and the second horizontal direction Y. A plurality of fixing devices 310 are mounted on the rotatable table 300. The plurality of fixing devices 310 are arranged around the periphery of rotatable table 300 and separated from each other. The rotatable table 300 is adapted to rotate the plurality of fixing devices 310 in turn to an assembling station where the robot 100 performs an assembly work of mounting electronic devices 1 on the circuit boards 2 fixed on one fixing device 310.

As shown in Fig.1, in an embodiment, after the assembly work of all circuit boards 2 on one fixing device 310 is completed, the rotatable table 310 is rotated forward by one step to move the assembled circuit boards 2 to an unloading station and move the unassembled circuit boards 2 fixed on another fixing device 310 to the assembling station.

As shown in Fig.1, the plurality of circuit boards 2 fixed on each fixing devices 310 are arranged in an array.

As shown in Fig.1, in an embodiment, the moving mechanism 210, 220 mainly comprises a first horizontal moving mechanism 210 and a second horizontal moving mechanism 220. The first horizontal moving mechanism 210 is adapted to move the second vision system 20 in the first horizontal direction X. The second horizontal moving mechanism 220 is adapted to move the second vision system 20 in the second horizontal direction Y. The second horizontal moving mechanism 220 is mounted on the first horizontal moving mechanism 210, and the second vision system 20 is mounted on the second horizontal moving mechanism 220. Thereby, the second vision system 20 may be moved in the first horizontal direction X and the second horizontal direction Y.

As shown in Fig.1, the electronic device 1 may comprise but not limited to an electronic component, such as a resistance, an inductance, a capacitance, a terminal of a connector or the like, an electronic product, such as a connector, or the like, or an electronic subassembly, such as, a chip, an electronic module or the like.

As shown in Fig.1, the first vision system 10 is also configured to detect whether the electronic device 1 gripped by the robot 100 is qualified. For example, the first vision system 10 is adapted to detect whether a size and an appearance of the electronic device 1 gripped by the robot 100 meets a predetermined requirement.

As shown in Fig.1, the second vision system 20 is also configured to detect whether the circuit board 2 fixed on the fixing device 310 is qualified. For example, the second vision system 20 is adapted to detect whether a size and an appearance of the circuit board 2 fixed on the fixing device 310 meets a predetermined requirement.

In an exemplary embodiment of the present disclosure, the robot 100 may be a multi-degree-of-freedom robot, for example, the robot 100 may be a six-axis robot with six degrees of freedom.

Furthermore, there is also provided a method of assembling the electronic devices 1 on the circuit boards 2. The method mainly comprises steps of:
S100: providing the above assembly system;
S200: moving the unassembled circuit boards 2 fixed on one fixing device 310 to the assemble station by rotating the rotatable table 310 forward by one step;
S300: synchronously performing following steps S310 and S320:
   S310: gripping the electronic device 1 by the robot 100, and identifying the position and the posture of the electronic device 1 by the first vision system 10;
   S320: moving the second vision system 20 by the moving mechanism 210, 220, and identifying the position and the posture of the unassembled circuit boards 2 fixed on the one fixing device 310 step by step by the second vision system 20;
S400: mounting the gripped electronic device 1 on the circuit board 2 by the robot 100 under the visual guidance of the first vision system 10 and the second vision system 20.

In an embodiment of the present disclosure, the method may further comprise a step of:
S500: rotating the rotatable table 310 forward by one step, so as to move the assembled circuit boards 2 fixed on the one fixing device 310 to the assembling station and move the unassembled circuit boards 2 fixed on another fixing device 310 to the unloading station.

In an embodiment of the present disclosure, the step S310 may further comprise a step of detecting whether the electronic device 1 gripped by the robot 100 is qualified by the first vision system 10; and the step S320 may further comprise a step of detecting whether the unassembled circuit boards 2 fixed on the one fixing device 310 is qualified by the second vision system 20.

Furthermore, the first vision system 10 and the second vision system 20 each may comprise a camera.

It should be appreciated for those skilled in this art that the above embodiments are intended to be illustrated, and not restrictive. For example, many modifications may be made to the above embodiments by those skilled in this art.

As used herein, an element recited in the singular and proceeded with the word "a" or "an" should be understood as not excluding plural of said elements or steps, unless such exclusion is explicitly stated. Furthermore, references to "one embodiment" of the present disclosure are not intended to be interpreted as excluding the existence of additional embodiments that also incorporate the recited features. Moreover, unless explicitly stated to the contrary, embodiments "comprising" or "having" an element or a plurality of elements having a particular property may include additional such elements not having that property.

## Claims

1. An assembly system, comprising:
a robot (100) adapted to grip an electronic device (1) to be mounted on a circuit board (2);
a first vision system (10) configured to identify a position and a posture of the electronic device (1) gripped by the robot (100);
a fixing device (310) adapted to fix a plurality of circuit boards (2) thereon; and
a second vision system (20) configured to identify a position and a posture of the circuit board (2) fixed on the fixing device (310),
wherein the robot (100) is adapted to mount the gripped electronic device (1) on the circuit board (2) under the visual guidance of the first vision system (10) and the second vision system (20),
and a view field of the second vision system (20), when the plurality of circuit boards (2) is fixed on the fixing device (310), is not capable of completely covering a surface region of all circuit boards (2) fixed on the fixing device (310); and
wherein the assembly system further comprises a moving mechanism (210, 220) adapted to move the second vision system (20) in a first horizontal direction (X) and a second horizontal direction (Y) perpendicular to the first horizontal direction (X), so that the second vision system (20) completes identification of all circuit boards (2) on the fixing device (310) step by step,
**characterized in that** the assembly system further comprises
a rotatable table (300) on which a plurality of fixing devices (310) are mounted,
wherein the plurality of fixing devices (310) are arranged around the periphery of rotatable table (300) and separated from each other,
wherein the rotatable table (300) is adapted to rotate the plurality of fixing devices (310) in turn to an assembling station where the robot (100) performs an assembly work of mounting electronic devices (1) on the circuit boards (2) fixed on one fixing device (310).

2. The assembly system according to claim 1, wherein
after the assembly work of all circuit boards (2) on one fixing device (310) is completed, the rotatable table (310) is rotated forward by one step to move the assembled circuit boards (2) to an unloading station and move the unassembled circuit boards (2) fixed on another fixing device (310) to the assembling station.

3. The assembly system according to claim 1 or 2,
wherein the moving mechanism (210, 220) comprising:
a first horizontal moving mechanism (210) adapted to move the second vision system (20) in the first horizontal direction (X); and
a second horizontal moving mechanism (220) adapted to move the second vision system (20) in the second horizontal direction (Y),
wherein the second horizontal moving mechanism (220) is mounted on the first horizontal moving mechanism (210), and the second vision system (20) is mounted on the second horizontal moving mechanism (220).

4. The assembly system according to claim 3,
wherein the first vision system (10) is adapted to detect whether a size and an appearance of the electronic device (1) gripped by the robot (100) meets a predetermined requirement.

5. The assembly system according to claim 4,
wherein the second vision system (20) is adapted to detect whether a size and an appearance of the circuit board (2) fixed on the fixing device (310) meets a predetermined requirement.

6. A method of assembling a circuit board, comprising steps of:
S100: providing the assembly system according to claim 1;
S200: moving the unassembled circuit boards (2) fixed on one fixing device (310) to the assemble station by rotating the rotatable table (310) forward by one step;
S300: synchronously performing following steps S310 and S320:
S310: gripping the electronic device (1) by the robot (100), and identifying the position and the posture of the electronic device (1) by the first vision system (10);
S320: moving the second vision system (20) by the moving mechanism (210, 220), and identifying the position and the posture of the unassembled circuit boards (2) fixed on the one fixing device (310) step by step by the second vision system (20);
S400: mounting the gripped electronic device on the circuit board by the robot under the visual guidance of the first vision system and the second vision system .

7. The method according to claim 6, further comprising a step of:
S500: rotating the rotatable table forward by one step, so as to move the assembled circuit boards fixed on the one fixing device to the assembling station and move the unassembled circuit boards fixed on another fixing device to the unloading station.

8. The method according to claim 6 or 7,
wherein the step S310 further comprises a step of detecting whether the electronic device gripped by the robot is qualified by the first vision system ; and
wherein the step S320 further comprises a step of detecting whether the unassembled circuit boards fixed on the one fixing device is qualified by the second vision system .

## Patentansprüche

1. Bestückungs-System, das umfasst:
einen Roboter (100), der so eingerichtet ist, dass er eine auf einer Leiterplatte (2) zu montierende elektronische Vorrichtung (1) ergreift;
ein erstes Sicht-System (10), das so ausgeführt ist, dass es eine Position und eine Stellung der von dem Roboter (100) ergriffenen elektronischen Vorrichtung (1) erkennt;
eine Fixiervorrichtung (310), die zum Fixieren einer Vielzahl von Leiterplatten (2) daran eingerichtet ist; sowie
ein zweites Sicht-System (20), das so ausgeführt ist, dass es eine Position und eine Stellung der an der Fixiervorrichtung (310) fixierten Leiterplatte (2) erkennt;
wobei der Roboter (100) so eingerichtet ist, dass er die ergriffene elektronische Vorrichtung (1) von dem ersten Sicht-System (10) und dem zweiten Sicht-System (20) optisch geführt auf der Leiterplatte (2) montiert,
und ein Sichtfeld des zweiten Sicht-Systems (20), wenn die Vielzahl von Leiterplatten (2) an der Fixiervorrichtung (310) fixiert ist, nicht in der Lage ist, einen Oberflächenbereich aller an der Fixiervorrichtung (310) fixierten Leiterplatten (2) vollständig abzudecken; und
wobei das Bestückungs-System des Weiteren einen Bewegungsmechanismus (210, 220) umfasst, der so eingerichtet ist, dass er das zweite Sicht-System (20) in einer ersten horizontalen Richtung (X) und einer zweiten horizontalen Richtung (Y) senkrecht zu der ersten horizontalen Richtung (X) bewegt, so dass das zweite Sicht-System (20) Erkennung aller Leiterplatten (2) an der Fixiervorrichtung (310) Schritt für Schritt abschließt,
**dadurch gekennzeichnet, dass** das Bestückungs-System des Weiteren umfasst:
einen drehbaren Tisch (300), auf dem eine Vielzahl von Fixiervorrichtungen (310) angebracht sind,
wobei die Vielzahl von Fixiervorrichtungen (310) um den Umfang des drehbaren Tischs (300) herum angeordnet und voneinander getrennt sind,
und der drehbare Tisch (300) so eingerichtet ist, dass er die Vielzahl von Fixiervorrichtungen (310) der Reihe nach zu einer Bestückungs-Station dreht, an der der Roboter (100) einen Bestückungsvorgang zum Montieren elektronischer Vorrichtungen (1) an den an einer Fixiervorrichtung (310) fixierten Leiterplatten (2) durchführt.

2. Bestückungs-System nach Anspruch 1, wobei
nachdem der Bestückungsvorgang aller Leiterplatten (2) an einer Fixiervorrichtung (310) abgeschlossen ist, der drehbare Tisch (310) um einen Schritt vorwärts gedreht wird, um die bestückten Leiterplatten (2) zu einer Abnahmestation zu bewegen und die an einer anderen Fixiervorrichtung (310) fixierten unbestückten Leiterplatten (2) zu der Bestückungs-Station zu bewegen.

3. Bestückungs-System nach Anspruch 1 oder 2,
wobei der Bewegungsmechanismus (210, 220) umfasst:
einen ersten Horizontal-Bewegungsmechanismus (210), der so eingerichtet ist, dass er das zweite Sicht-System (20) in der ersten horizontalen Richtung (X) bewegt; und
einen zweiten Horizontal-Bewegungsmechanismus (220), der so eingerichtet ist, dass er das zweite Sicht-System (20) in der zweiten horizontalen Richtung (Y) bewegt,
wobei der zweite Horizontal-Bewegungsmechanismus (220) an dem ersten Horizontal-Bewegungsmechanismus (210) angebracht ist und das zweite Sicht-System (20) an dem zweiten Horizontal-Bewegungsmechanismus (220) angebracht ist.

4. Bestückungs-System nach Anspruch 3,
wobei das erste Sicht-System (10) so eingerichtet ist, dass es erfasst, ob eine Größe und ein Erscheinungsbild der von dem Roboter (100) ergriffenen elektronischen Vorrichtung (1) eine vorgegebene Anforderung erfüllt.

5. Bestückungs-System nach Anspruch 4,
wobei das zweite Sicht-System (20) so eingerichtet ist, dass es erfasst, ob eine Größe und ein Erscheinungsbild der an der Fixiervorrichtung (310) fixierten Leiterplatte (2) eine vorgegebene Anforderung erfüllt.

6. Verfahren zum Bestücken einer Leiterplatte, das die folgenden Schritte umfasst:
S100: Bereitstellen des Bestückungs-Systems nach Anspruch 1;
S200: Bewegen der an einer Fixiervorrichtung (310) fixierten unbestückten Leiterplatten (2) zu der Bestückungs-Station durch Drehen des Drehtischs (310) um einen Schritt vorwärts;
S300: synchrones Durchführen der folgenden Schritte S310 und S320:
S310: Ergreifen der elektronischen Vorrichtung (1) durch den Roboter (100) und Erkennen der Position sowie der Stellung der elektronischen Vorrichtung (1) durch das erste Sicht-System (10);
S320: Bewegen des zweiten Sicht-Systems (20) durch den Bewegungsmechanismus (210, 220) und schrittweises Erkennen der Position sowie der Stellung der an der einen Fixiervorrichtung (310) fixierten unbestückten Leiterplatten (2) durch das zweite Sicht-System (20);
S400: Montieren der ergriffenen elektronischen Vorrichtung auf der Leiterplatte durch den Roboter optisch geführt von dem ersten Sicht-System und dem zweiten Sicht-System.

7. Verfahren nach Anspruch 6, das des Weiteren einen folgenden Schritt umfasst:
S500: Drehen des Drehtischs um einen Schritt vorwärts, um die an der Fixiervorrichtung fixierten bestückten Leiterplatten zu der Bestückungs-Station zu bewegen und die an einer anderen Fixiervorrichtung fixierten unbestückten Leiterplatten zu der Abnahmestation zu bewegen.

8. Verfahren nach Anspruch 6 oder 7,
wobei der Schritt S310 des Weiteren einen Schritt umfasst, in dem erfasst wird, ob die von dem Roboter ergriffene elektronische Vorrichtung durch das erste Sicht-System autorisiert wird; und
wobei der Schritt S320 des Weiteren einen Schritt umfasst, in dem erfasst wird, ob die an der einen Fixiervorrichtung fixierten unbestückten Leiterplatten durch das zweite Sicht-System autorisiert werden.

## Revendications

1. Système d'assemblage, comprenant:
un robot (100) conçu pour saisir un dispositif électronique (1) pour montage sur une carte de circuit imprimé (2);
un premier système de vision (10) configuré pour identifier une position et une posture du dispositif électronique (1) saisi par le robot (100);
un dispositif de fixation (310) conçu pour fixer une pluralité de cartes de circuits imprimés (2) sur celui-ci; et
un second système de vision (20) configuré pour identifier une position et une posture de la carte de circuit imprimé (2) fixée sur le dispositif de fixation (310),
dans lequel le robot (100) est conçu pour monter le dispositif électronique saisi (1) sur la carte de circuit imprimé (2) sous le guidage visuel du premier système de vision (10) et du second système de vision (20),
et un champ de vision du système de vision secondaire (20), lorsque la pluralité de cartes de circuits imprimés (2) est fixée sur le dispositif de fixation (310), n'est pas capable de couvrir complètement une zone de surface de toutes les cartes de circuits imprimés (2) fixées sur le dispositif de fixation (310); et
dans lequel le système d'assemblage comprend en outre un mécanisme de déplacement (210, 220) conçu pour déplacer le second système de vision (20) dans une première direction horizontale (X) et une seconde direction horizontale (Y) perpendiculaire à la première direction horizontale (X), de sorte que le second système de vision (20) achève l'identification de toutes les cartes de circuits imprimés (2) sur le dispositif de fixation (310) étape par étape,
**caractérisé en ce que** le système d'assemblage comprend en outre
une table rotative (300) sur laquelle sont montés plusieurs dispositifs de fixation (310),
dans lequel la pluralité de dispositifs de fixation (310) sont disposés autour de la périphérie de la table rotative (300) et séparés les uns des autres,
dans lequel la table rotative (300) est conçue pour faire tourner la pluralité de dispositifs de fixation (310) à tour de rôle vers une station d'assemblage où le robot (100) effectue un travail d'assemblage consistant à monter des dispositifs électroniques (1) sur les cartes de circuits imprimés (2) fixées sur un dispositif de fixation (310).

2. Système d'assemblage selon la revendication 1, dans lequel
une fois que le travail d'assemblage de toutes les cartes de circuits imprimés (2) sur un dispositif de fixation (310) est terminé, la table rotative (310) est tournée d'un pas vers l'avant pour déplacer les cartes de circuits imprimés (2) assemblées vers une station de déchargement et déplacer les cartes de circuits imprimés (2) non assemblées fixées sur un autre dispositif de fixation (310) vers la station d'assemblage.

3. Système d'assemblage selon les revendications 1 ou 2,
dans lequel le mécanisme de déplacement (210, 220) comprend:
un premier mécanisme de déplacement horizontal (210) conçu pour déplacer le second système de vision (20) dans la première direction horizontale (X); et
un second mécanisme de déplacement horizontal (220) conçu pour déplacer le second système de vision (20) dans la seconde direction horizontale (Y),
dans lequel le second mécanisme de déplacement horizontal (220) est monté sur le premier mécanisme de déplacement horizontal (210), et le second système de vision (20) est monté sur le second mécanisme de déplacement horizontal (220).

4. Système d'assemblage selon la revendication 3,
dans lequel le premier système de vision (10) est conçu pour détecter si une taille et une apparence du dispositif électronique (1) saisi par le robot (100) répondent à une exigence prédéterminée.

5. Système d'assemblage selon la revendication 4,
dans lequel le second système de vision (20) est conçu pour détecter si une taille et une apparence de la carte de circuit imprimé (2) fixée sur le dispositif de fixation (310) répondent à une exigence prédéterminée.

6. Procédé d'assemblage d'une carte de circuit imprimé, comprenant les étapes suivantes:
S100: fournir le système d'assemblage selon la revendication 1;
S200: déplacement des cartes de circuits imprimés non assemblées (2) fixées sur un dispositif de fixation (310) vers la station d'assemblage en faisant tourner la table rotative (310) d'un pas vers l'avant;
S300: exécution synchrone des étapes S310 et S320 suivantes:
S310: saisie du dispositif électronique (1) par le robot (100), et identification de la position et de la posture du dispositif électronique (1) par le premier système de vision (10);
S320: déplacement du système de vision secondaire (20) par le mécanisme de déplacement (210, 220), et identification de la position et de la posture des cartes de circuits imprimés non assemblées (2) fixées sur le dispositif de fixation (310) pas à pas par le système de vision secondaire (20);
S400: montage du dispositif électronique saisi sur la carte de circuit imprimé par le robot sous le guidage visuel du premier système de vision et du second système de vision.

7. Procédé selon la revendication 6, comprenant en outre une étape de :
S500: rotation de la table tournante d'un pas vers l'avant, de manière à déplacer les cartes de circuit assemblées fixées sur un dispositif de fixation vers la station d'assemblage et les circuits imprimés non assemblés fixés sur un autre dispositif de fixation vers la station de déchargement.

8. Procédé selon les revendications 6 ou 7,
dans lequel l'étape S310 comprend en outre une étape consistant à détecter si le dispositif électronique saisi par le robot est qualifié par le premier système de vision; et
dans lequel l'étape S320 comprend en outre une étape consistant à détecter si les cartes de circuits imprimés non assemblées fixées sur le dispositif de fixation sont qualifiées par le second système de vision.
